# EUROPÄISCHE PATENTANMELDUNG

(11) **EP 1 939 635 A1**
(43) Veröffentlichungstag der Anmeldung: **02.07.2008**
(21) Anmeldenummer: 07122145.1
(22) Anmeldetag: 03.12.2007
(51) Int. Cl.: G01R 15/20

(54) **Vorrichtung zur Messung der Stromstärke in einem Leiter**

(30) Priorität: 27.12.2006 DE 102006062321
(71) Anmelder: SIEMENS AKTIENGESELLSCHAFT, 80333 München (DE)
(72) Erfinder: Hein, Gerd, 91074, Herzogenaurach (DE); Steinbauer, Jochen, 91074, Herzogenaurach (DE)

(57) **Zusammenfassung**

Die Erfindung betrifft eine Vorrichtung zur Messung der Stromstärke in einem Leiter, wobei in einer schlitzartigen Ausnehmung zwei Hallsensoren angeordnet sind. Es ist vorgesehen, dass der Leiter Teil einer Bahnstromversorgung ist und dass sich die schlitzartige Ausnehmung direkt im Leiter befindet. Beispielsweise sind die Hallsensoren auf einer Leiterplatte, die eine Auswerteeinheit trägt, zur Bildung eines Hallelements angeordnet. Das Hallelement ist beispielsweise in der Ausnehmung durch Isolatormaterial vom Leiter getrennt.

## Beschreibung

Die Erfindung betrifft eine Vorrichtung zur Messung der Stromstärke in einem Leiter, wobei in einer schlitzartigen Ausnehmung zwei Hallsensoren angeordnet sind.

Eine derartige Vorrichtung ist aus der DE 195 49 181 A1 bekannt. Bei dem dort beschriebenen Leiter sind Schlitze vorgesehen, in die zwei Hallsensoren eingefügt sind. In üblicher Weise wird mit den Hallsensoren die Stromstärke des durch den Leiter fließenden Stromes gemessen. Der bekannte Leiter ist in der Regel eine Stromschiene, die für die Versorgung von Elektrokraftfahrzeugen mit elektrischer Energie dienen kann.

Aus der DE 199 08 652 C1 geht hervor, dass zwei Hallsensoren zur Messung der Stromstärke in einem Leiter als Hallelement ausgebildet sein können. Dieses Hallelement ist in einer schlitzartigen Ausnehmung des Leiters positioniert.

Zur Messung der Stromstärke in Anlagen der Bahnstromversorgung wurden bisher stets so genannte Shuntwiderstände eingesetzt. Dabei wird der Spannungsabfall am Widerstand gemessen und daraus die Stromstärke bestimmt. Von dieser Messmethode wurde in der Fachwelt seit längerer Zeit nicht abgewichen, da man stets davon ausging, dass eine korrekte Messung direkt am Leiter erfolgen müsse. Die Vorrichtung mit Shuntwiderständen ist jedoch schwer und benötigt viel Platz und arbeitet verlustreich.

Der Erfindung liegt die Aufgabe zugrunde, eine einfache, relativ kleine und relativ leichte Vorrichtung zur Messung der Stromstärke in einem Leiter anzugeben, die zuverlässig arbeitet und somit in Anlagen der Bahnstromversorgung eingesetzt werden kann.

Die Aufgabe wird gemäß der Erfindung dadurch gelöst, dass der Leiter, in dem die Stromstärke gemessen werden soll, Teil einer Bahnstromversorgung ist und dass sich die schlitzartige Ausnehmung, in der die Hallsensoren angeordnet sind, direkt im Leiter befindet.

Man erhält für die Bahnstromversorgung eine einfache kostengünstige und wenig Platz beanspruchende und damit vorteilhafte Vorrichtung zur Messung der Stromstärke, die zuverlässig arbeitet, weil die Hallsensoren im Magnetfeld des Leiters angeordnet sind. Die Vorrichtung eignet sich vorteilhaft für die Stromstärkemessung in Gleichstrombahnsystemen, ist aber auch in Wechselstrombahnsystemen einsetzbar.

Es wird das bisherige Vorurteil der Fachleute überwunden, dass bei der Bahnstromversorgung die Störströme für den Einsatz von Hallsensoren zu groß wären.

Die Hallsensoren sind beispielsweise auf einer Leiterplatte, die eine Auswerteeinrichtung trägt, zur Bildung eines Hallelements angeordnet. Die Hallsensoren und die Auswerteeinrichtung bilden also zusammen das Hallelement.

Beispielsweise ist das Hallelement in der Ausnehmung durch Isolatormaterial vom Leiter getrennt. Da das Hallelement eine Auswerteeinrichtung umfasst, muss es von den vergleichsweise hohen Spannungen am Leiter geschützt werden. Anderenfalls würde die Auswerteeinrichtung Schaden nehmen.

Beispielsweise ist der Zwischenraum zwischen dem Hallelement und dem Leiter in der Ausnehmung mit einem Isolatormaterial vergossen. Damit wird neben der Isolierwirkung der Vorteil erzielt, dass das Hallelement in der schlitzartigen Ausnehmung zuverlässig positioniert ist.

Nach einem anderen Beispiel sind die Hallsensoren auf einer aus Isolatormaterial bestehenden, das Hallelement gegen den Leiter isolierenden Leiterplatte angeordnet. Es wird der Vorteil erzielt, dass die Leiterplatte selbst aus einem isolierenden Grundstoff besteht, der, falls die Leiterplatte einseitig bestückt ist, die notwendige Isolierung vom Leiter übernimmt. Es wird keine separate Isolierung benötigt.

Insbesondere ist es dazu notwendig, dass zwei Leiterplatten in der schlitzartigen Ausnehmung angeordnet sind, wobei die isolierenden Teile der Leiterplatten jeweils der Leiteroberfläche in der schlitzartigen Ausnehmung zugewandt sind.

Beispielsweise ist das Hallelement zur Eigenversorgung mit elektrischer Energie über einen Spannungsteiler mit dem Leiter verbunden. Damit wird der Vorteil erzielt, dass die erforderliche niedrige Versorgungsspannung zur Eigenversorgung des Hallelementes nicht separat zur Verfügung stehen muss, sondern durch Umformung aus der Gleichspannung der Bahnversorgung entnommen wird.

Beispielsweise ist auf der Leiterplatte eine Einrichtung zur Eigenversorgung des Hallelementes mit elektrischer Energie implementiert.

Mit den Maßnahmen zur Eigenversorgung des Hallelements mit elektrischer Energie wird der zusätzliche Vorteil erzielt, dass keine besondere Energieversorgung notwendig ist.

Die mit der Auswerteeinheit erzielten Resultate können in üblicher Weise zu einer Zentrale übermittelt werden. Dazu kann eine Infrarotübermittlung oder eine Funkübertragung dienen.

Es können auch mehrere Hallelemente eingesetzt werden. Ein Hallelement kann einen oder mehrere Hallsensoren umfassen.

Mit der Vorrichtung nach der Erfindung wird insbesondere der Vorteil erzielt, dass die Stromstärke in einem Leiter, der Teil einer Bahnstromversorgung ist, mit einfachen Mitteln zuverlässig gemessen werden kann.

Eine Kombination der neuen Messvorrichtung mit der bisherigen Messvorrichtung, die Shuntwiderstände verwendet, ist weiterhin möglich.

## Patentansprüche

1. Vorrichtung zur Messung der Stromstärke in einem Leiter, wobei in einer schlitzartigen Ausnehmung zwei Hallsensoren angeordnet sind, **dadurch gekennzeichnet, dass** der Leiter Teil einer Bahnstromversorgung ist und dass sich die schlitzartige Ausnehmung direkt im Leiter befindet.

2. Vorrichtung nach Anspruch 1, **dadurch gekennzeichnet, dass** die Hallsensoren auf einer Leiterplatte, die eine Auswerteeinheit trägt, zur Bildung eines Hallelements angeordnet sind.

3. Vorrichtung nach Anspruch 2, **dadurch gekennzeichnet, dass** das Hallelement in der Ausnehmung durch Isolatormaterial vom Leiter getrennt ist.

4. Vorrichtung nach Anspruch 3, **dadurch gekennzeichnet, dass** der Zwischenraum zwischen Hallelement und Leiter in der Ausnehmung mit dem Isolatormaterial vergossen ist.

5. Vorrichtung nach Anspruch 3, **dadurch gekennzeichnet, dass** die Hallsensoren auf einer aus Isolatormaterial bestehenden, das Hallelement gegen den Leiter isolierenden Leiterplatte angeordnet sind.

6. Vorrichtung nach einem der Ansprüche 2 bis 5, **dadurch gekennzeichnet, dass** das Hallelement zur Eigenversorgung mit elektrischer Energie über einen Spannungsteiler mit dem Leiter verbunden ist.

7. Vorrichtung nach einem der Ansprüche 2 bis 5, **dadurch gekennzeichnet, dass** auf der Leiterplatte eine Einrichtung zur Eigenversorgung des Hallelementes mit elektrischer Energie implementiert ist.
